# EUROPEAN PATENT SPECIFICATION

(11) **EP 1 496 078 B1**
(45) Date of publication and mention of the grant of the patent: **20.06.2007**
(21) Application number: 04254063.3
(22) Date of filing: 07.07.2004
(51) Int. Cl.: C08G 73/14, C08L 79/08, C09J 179/08, C09D 179/08

(54) **Polyamideimide resin, method for producing polyamideimide resin, polyamideimide resin composition containing the same, film-forming material and adhesive for electronic parts made thereof**
Polyamidimidharz, Verfahren zu seiner Herstellung, Polyamidimidzusammensetzung, daraus hergestellte filmbildendes Material und Klebstoff für elektronische Teile
Résine polyamideimide, procédé pour sa fabrication, composition de polyamideimide, matériau filmogène et colle pour composants électroniques à base de celle-ci

(30) Priority: 07.07.2003 JP 2003193031; 27.01.2004 JP 2004018655
(43) Date of publication of application: 12.01.2005
(73) Proprietor: NITTO DENKO CORPORATION, Ibaraki-shi, Osaka 567-8680 (JP)
(72) Inventor: Hikita, Takami, c/o Nitto Denko Corporation, Ibaraki-shi Osaka 567-8680 (JP); Kondo, Takashi, c/o Nitto Denko Corporation, Ibaraki-shi Osaka 567-8680 (JP); Mochizuki, Amane, c/o Nitto Denko Corporation, Ibaraki-shi Osaka 567-8680 (JP)
(74) Representative: Fairbairn, Angus Chisholm

(56) References cited:
- EP-A- 1 048 680
- PATENT ABSTRACTS OF JAPAN vol. 2000, no. 06, 22 September 2000 (2000-09-22) & JP 2000 086888 A (HITACHI CHEM CO LTD), 28 March 2000 (2000-03-28)

## Description

The present invention relates to a polyamideimide resin, a method for producing the polyamideimide resin, a polyamideimide resin composition, a film-forming material and an adhesive for electronic parts using the polyamideimide resin or polyamideimide resin composition.

Polyamide resins, polyamideimide resins and polyimide resins have been used in recent years in the fields of electronic materials in place of epoxy resins as heat-resistant resins being excellent in heat resistance, electric characteristics, adhesivity, hygroscopicity and workability. However, irrespective of their excellent characteristics as described above, these resins are high elastic so as to occur poor adhesivity to the substrate when used as coating films due to their highly rigid resin structure while softness and bendability of hardened films are poor due to their low flexibility.

For solving these problems, there is proposed an aromatic polyamide-acrylonitrile-butadiene copolymer that is made to have a low elastic modulus by giving the resin flexibility by using acrylonitrile-butadiene having carboxylic acid terminals (cf. Japanese Patent Application Laid-Open Nos. 02-245032 and 03-47836). The polyamide polymer contained in the polyamide resin has polymer framework given flexibility by a structural unit derived from butadiene-containing dicarboxylic acid. Therefore, a coating film thus obtained has low elasticity and hence can have significantly improved adhesivity and flexibility.

However, the polyamide resin disclosed in the conventional arts involves a problem of causing a decrease of insulation characteristics due to remaining ionic impurities derived from a phosphorus-base condensing agent in the polymer since the polymer is polymerized in the presence of the phosphorus-base condensing agent.

Accordingly, it is an object of the invention to provide a resin and resin composition having low elasticity and being excellent in flexibility while being excellent in heat resistance, electric characteristics and adhesivity, as well as a film-forming material comprising the resin or resin composition, and an adhesive for electronic parts.

The present inventors have noticed the polyamideimide resin having excellent properties such as heat resistance, low hygroscopicity and excellent electric characteristics, particularly excellent insulation characteristics, as compared with polyamide resins.

The inventors have investigated to use aromatic isocyanate compounds as starting materials for suppressing eliminated components from being formed in the polymerization process to reduce the content of the impurities in the polymer. The aromatic isocyanate compound is known to form various bonds by reacting with various nucleophiles due to its high reactivity. By heating, an imide compound is obtained from a reaction between the aromatic isocyanate compound and an acid anhydride, and an amide compound is obtained from a reaction between the aromatic isocyanate compound and a carboxylic acid.

The present inventors have applied the reactions described above to a reaction of an acid dianhydride and an acrylonitrile-butadiene having terminal carboxylic acids with respect to an aromatic diisocyanate, and have found that it is possible to produce the polyamideimide resin that is excellent in flexibility while suppressing eliminated components from being formed in the polymerization process to reduce the content of impurities in the polymer. Thus, the present invention has been completed based on these studies.

According to an aspect of the present invention, there is provided a polyamideimide resin comprising a structural unit represented by the following general formula (1) and at least one of the structural unit represented by the following general formula (2) and the structural unit represented by the following general formula (3), and containing a polyamideimide copolymer with a number average molecular weight of 2000 to 50000. Wherein the number k of the structural unit represented by the general formula (1), the number m of the structural unit represented by the general formula (2), and the number n of the structural unit represented by the general formula (3) contained in the polyamide resin satisfy the relation of 0 < m/(k + m + n) ≤ 0.1: 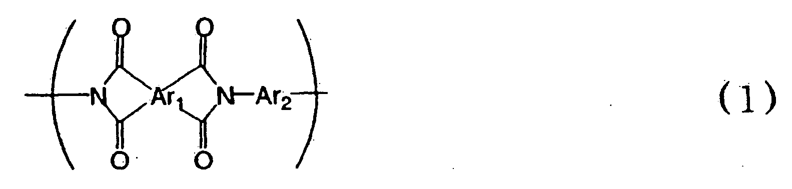 (wherein, Ar₁ and Ar₂ each represent an aromatic group that may be substituted) 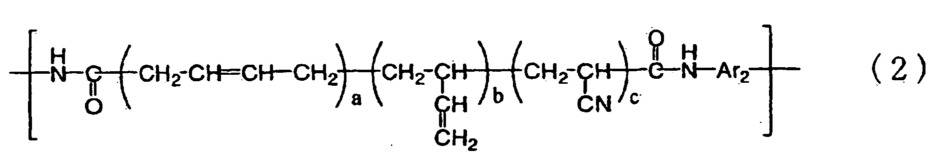 (wherein, Ar₂ is defined as described above, and a, b and c each is an integer of 0 to 100 with the relations of the ratio a/b of 0/1 to 1/0, the ratio (a + b)/c of 1/0 to 0/1, and the sum (a + b + c) of 1 to 100) 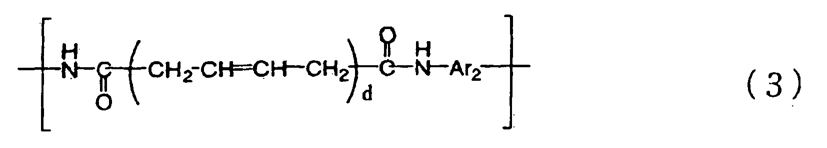 (wherein, Are is defined as described above, and d is an integer of 1 to 100).

Since the copolymer contained in the polyamideimide resin of the present invention has a structural unit derived from the butadiene-containing dicarboxylic acid in the frame thereof, the elastic modulus of the resulting hardened resin decreases to make the resin to be excellent in adhesivity and flexibility. In addition, the resin is excellent in insulation characteristics and hygroscopic reflow characteristics as compared with the resin using the polyamide resin.

According to another aspect of the present invention, there is provided a method for producing the polyamideimide resin comprising the steps of: obtaining the structural unit represented by the general formula (1) by imidation by a decarboxylation reaction between an aromatic diisocyanate represented by the following general formula (4) and an aromatic tetracarboxylic acid dianhydride represented by the following general formula (5); obtaining the structural unit represented by the general formula (2) by amidation by a decarboxylation reaction between an aromatic diisocyanate represented by the following general formula (4) and a dicarboxylic acid represented by the following general formula (6); and obtaining the structural unit represented by the general formula (3) by amidation by a decarboxylation reaction between an aromatic diisocyanate represented by the following general formula (4) and a dicarboxylic acid represented by the following general formula (7):

OCN-Ar₂-NCO (4)

(wherein, Ar₂ is defined as described above) 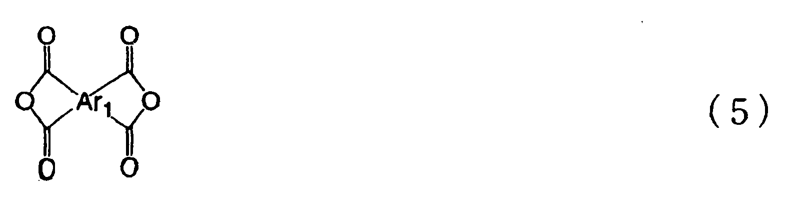 (wherein, Ar₁ is defined as described above) 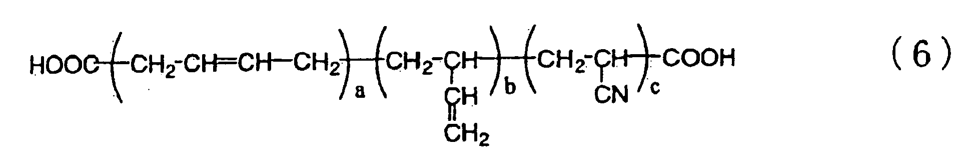 (wherein, a, b and c are defined as described above) 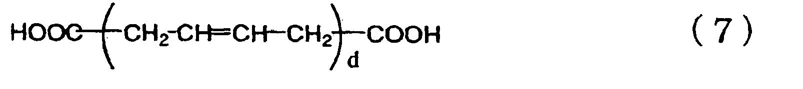 (wherein, d is defined as described above)

According to the production method as described above, the amount of the phosphorus-base condensing agent to be used is reduced to enable lower hygroscopicity of the resin than the polyamide resin to be attained, since the highly reactive aromatic diisocyanate compound is used as a substance for obtaining an imide bond by permitting it to react with the aromatic tetracarboxylic acid dianhydride, and as a substance for obtaining an amide bond by permitting it to react with a butadiene-containing dicarboxylic acid. The amount of ionic impurities originating from the phosphorous-base condensing agent can be reduced in the polyamideimide resin to enable the insulation characteristics of the hardened resin to be suppressed from being lowered. Furthermore, since the resin becomes less hygroscopic as compared with the polyamide resin, the resin produced is also excellent in the hygroscopic reflow characteristics. Additionally, since a structural unit originating from the butadiene-containing dicarboxylic acid is formed in the polyamideimide copolymer frame in the hardened resin, flexibility may be imparted to the copolymer structure. Accordingly, the resulting hardened resin has a decreased elastic modulus and is excellent in adhesivity and flexibility.

According to still another aspect of the present invention, there is provided a polyamideimide resin in which the tetracarboxylic acid dianhydride is 2,2-bis[4-(3,4-dicarboxyphenoxy)phenyl]propane dianhydride represented by the following formula (8):

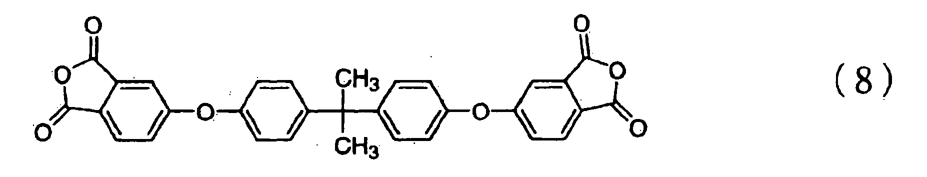

The polyamideimide resin containing the copolymer having the structure as described above is excellent in flexibility after hardening since the resin has good bendability. Containing many aromatic rings renders the resin excellent in laser processibility.

According to the present invention, there is further provided a polyamideimide resin composition comprising 10 to 100 parts by weight of an epoxy resin relative to 100 parts by weight of the polyamideimide resin.

According to a further aspect of the present invention, there is provided a coating film forming material and an adhesive for electronic parts comprising the polyamideimide resin or the polyamideimide resin composition.

The polyamideimide resin and polyamideimide resin composition of the present invention has a low elastic modulus and good adhesivity to a substrate while being excellent in electric characteristics and laser processibility.

The film-forming material and adhesive for electronic parts using the polyamideimide resin or polyamideimide resin composition may be favorably used for an adhesive film, interlayer insulation film, surface protective film or solder resist film in printed circuit boards by taking advantage of the excellent characteristics as described above.

The polyamideimide resin of the present invention contains a polyamideimide copolymer containing the structural unit represented by the general formula (1), and at least one of the structural unit represented by the general formula (2) and the structural unit represented by the general formula (3).

Ar₁ and Ar₂ in the general formula (1) are aromatic groups that may be substituted. Examples of the preferable aromatic groups include phenylene, naphthalene, tolylene, tolidine and diphenylmethane groups for Ar₁, and biphenyl, benzophenone and naphthalene groups for Ar₂. Examples of the preferable substituents include alkyl groups having a carbon number of 1 to 5 such as methyl and ethyl groups.

While a + b + c is 1 to 100 in the general formula (2), the value is preferably 5 to 90, more preferably 10 to 80. The value of a + b + c of less than 1 tends to fail in obtaining flexibility, while the value of a + b + c of exceeding 100 tends to decrease heat resistance and reactivity.

The ratio a/b is in the range of 1/0 to 0/1, preferably 1/0 to 1/4, and more preferably 1/0 to 2/3. The a/b ratio of 1/0 tends to decrease solubility of the resin, while the a/b ratio of 0/1 tends to improve heat resistance of the hardened resin.

The ratio (a + b)/c is in the range of 1/0 to 0/1, preferably 95/5 to 2/8, and more preferably 9/1 to 4/6. The ratio (a + b)/c of 0/1 tends to decrease electric resistance, while the ratio (a + b)/c of 1/0 tends to decrease heat resistance, solubility and adhesivity.

The polyamideimide resin of the present invention contains k, m and n structural units represented by the general formulae (1), (2) and (3), respectively, in the polyamideimide copolymer, in which k is an integer of no less than 1, and m and n are integers of no less than 0 (n and m are not simultaneously zero). The ratio m/(k + m + n) is in the range of 0 to 0.1 (not including zero), more preferably 0.01 to 0.07, and further preferably 0.02 to 0.05. Insulating property of the polyamideimide resin tends to be decreased when the ratio m/(k + m + n) exceeds 0.1, while compatibility with the epoxy resin decreases when the ratio is 0.

The resin containing 2,2-bis[4-(3,4-dicarboxyphenoxy)phenyl]propane dianhydride represented by the formula (8) in the structural unit in the general formula (1) is preferable considering flexibility and laser processibility.

While the number average molecular weight of the polyamideimide resin of the present invention is in the range of 2000 to 50000, it is preferably 5000-40000, more preferably 6000 to 30000 and further preferably 8000 to 20000. Film characteristics such as heat resistance tends to decrease when the number average molecular weight is less than 2000, while the resin becomes hardly soluble in the reaction solvent when the molecular weight exceeds 50000, and therefor easy to remain insoluble during the synthesis process. As a result, the workability tends to become poor.

The number average molecular weight was measured by gel permeation chromatography (GPC), and was calibrated using the molecular weight of polyethyleneglycol (PEG) as standard.

Practically, HLC-8120 GPC (manufactured by TOSOH Corp.) was used for GPC with a column temperature of 40°C and a pump flow rate of 0.4 mL/minutes. The detector used was an RI detector integrated in the GPC. The data was processed using a calibration curve of the standard PEG having known molecular weight (calibration at a molecular weight range of no less than 1000) to obtain a molecular weight calibrated by the molecular weight of PEG.
Column used: Super AWM-H + Super AWM-H + Super AW3000
Mobile phase: 10 mM LiBr + N-methyl pyrrolidone
Injection volume: 20 µl
Sample concentration: 0.1% (w/w)

While the molecular weight distribution is usually in the range of 3.0 to 12.0, it is preferably in the range of 2.0 to 10.0, and more preferably in the range of 2.0 to 8.0.

The molecular weight distribution is defined as the ratio (Mw/Mn) of the number average molecular weight (Mn) determined by above GPC to the weight average molecular weight (Mw).

The polyamideimide resin of the present invention is produced by the steps comprising: obtaining the structural unit represented by the general formula (1) by imidation by a decarboxylation reaction between the aromatic diisocyanate represented by the general formula (4) and the aromatic tetracarboxylic acid dianhydride represented by the general formula (5); obtaining the structural unit represented by the general formula (2) by amidation by a decarboxylation reaction between the aromatic diisocyanate represented by the general formula (4) and the butadiene-containing dicarboxylic acid represented by the general formula (6); obtaining the structural unit represented by the general formula (3) by amidation by a decarboxylation reaction between the aromatic diisocyanate represented by the general formula (4) and the butadiene-containing dicarboxylic acid represented by the general formula (7); and copolymerizing the obtained structural units.

Examples of the aromatic diisocyanate represented by the general formula (4) include phenylene-1,4-diisocyanate, phenylene-1,3-diisocyanate, 2,4-tolylene diisocyanate, 2,6-tolylene diisocyanate, 4,4'-diphenylmethane diisocyanate, 4,4'-diphenylether diisocyanate, 4,4'-[2,2-bis(4-phenoxyphenyl)propane]diisocyanate, naphthalene-1,5-diisocyanate, naphthalene-1,6-diisocyanate, biphenyl-4,4'-diisocyanate, 3,3'-dimethylbiphenyl-4,4'-diisocyanate and 2,2'-dimethylbiphenyl-4,4'-diisocyanate, but not restricted thereto. Each of these aromatic diisocyanates may be used alone, or as a combination of a plurality of them.

Tolylene diisocyanate is particularly preferable in consideration of a balance among mechanical characteristics, solubility and cost performance.

Examples of the aromatic tetracarboxylic acid dianhydride represented by the general formula (5) include pyromellitic acid dianhydride, 3,3',4,4'-benzophanone tetracarboxylic acid dianhydride, 3,3'4,4'-oxydiphthalic acid dianhydride, 3,3'4,4'-sulfonyldiphthalic acid dianhydride, 3,3',4,4'-biphenyl tetracarboxylic acid dianhydride, 1,2,5,6-naphthalene tetracarboxylic acid dianhydride, 2,3,5,6-pyridine tetracarboxylic acid dianhydride, 1,4,5,8-naphthalene tetracarboxylic acid dianhydride, 1,1,1,3,3,3-hexafluoro-2,2-bis(3,4-dicarboxyphenyl)propane dianhydride, 2,2-bis(3,4-dicarboxyphenyl)propane dianhydride, 2,2-bis[4-(3,4-dicarboxyphenoxy)phenyl]propane dianhydride, 1,1,1,3,3,3-hexafluoro-2,2-bis[4-(3,4-dicarboxyphenoxy)phenyl]propane dianhydride and butane tetracarboxylic acid dianhydride, but not restricted thereto. Each of them may be used alone, or as a combination of a plurality of them.

2,2-bis[4-(3,4-dicarboxyphenoxy)phenyl]propane dianhydride that is excellent in laser processibility is preferable among them since it exhibits bendability due to its ether bond.

Tricarboxylic acid anhydrides (such as trimellitic acid anhydride, 3,3,4-benzophenone tricarboxylic acid anhydride and 2,3,4'-diphenylether tricarboxylic acid anhydride) may be used in addition to the dianhydrides above, if necessary.

The dicarboxylic acids represented by the general formulae (6) and (7) are acrylonitrile-butadiene copolymer and butadiene having carboxylic groups at both terminal thereof. The number average molecular weight of these compound is preferably 1000 to 5000, and compounds known in the art may be used.

Examples of the acrylonitrile-butadiene copolymer represented by the general formula (6) and having carboxylic groups at both terminals include Hycar-RLP series polymers (for example CTBN 1300 × 8, CTBN 1300 × 13, CTBN 1300 × 31 and CTBNX 1300 × 9) manufactured by Ube Industries Ltd., but not restricted thereto.

Examples of the butadiene polymers represented by the general formula (7) and having carboxylic groups at both terminals include Nisso-PB series polymers (for example C-1000) manufactured by Nippon Soda Co., and Hycar-RLP series polymers (for example CTB 2000 × 162) manufactured by Ube Industries Ltd., but not restricted thereto.

Each of these polymers may be used alone, or as a combination of a plurality of them.

Aliphatic dicarboxylic acids (such as succinic acid, glutaric acid, adipic acid, azelaic acid, decane dicarboxylic acid, dodecane dicarboxylic acid and dimer acids), and aromatic dicarboxylic acids (isophthalic acid, terephthalic acid, phthalic acid and naphthalene dicarboxylic acid) may be used in addition to the dicarboxylic acids above, if necessary.

The total amount of the dicarboxylic acid represented by the general formula (6) or (7) to be compounded is preferably 20 to 80% by weight, more preferably 30 to 70% by weight, and further preferably 40 to 60% by weight relative to the polyamideimide copolymer. Adhesivity and flexibility tend to decrease when the amount to be compounded is less than 20% by weight, while heat resistance tends to be deteriorated when the amount of blending exceeds 80% by weight.

In the present invention, the blending ratio between the aromatic diisocyanate and aromatic tetracarboxylic acid dianhydride, and the blending ratio between the aromatic diisocyanate and dicarboxylic acid for synthesizing the polyamideimide copolymer are determined by the ratio of the total number of the isocyanate groups to the total number of the acid anhydride group and the carboxylic groups in dicarboxylic acid. This ratio is preferably 0.7 to 1.3, more preferably 0.8 to 1.2, and further preferably 0.9 to 1.1. It becomes rather difficult to sufficiently increase the molecular weight of the resin when the ratio is less than 0.7 or exceeds 1.3.

The polyamideimide copolymers of the present invention having the structural units represented by the general formulae (1), (2) and (3) may be obtained by simultaneously polymerizing the aromatic diisocyanate, aromatic tetracarboxylic acid dianhydride and dicarboxylic acid; or may be produced by reacting an excess amount of the aromatic diisocyanate with the aromatic tetracarboxylic acid dianhydride or dicarboxylic acid to obtain a polyimide or polyamide oligomer having isocyanate groups at the terminals, followed by polymerization by adding remaining aromatic tetracarboxylic acid dianhydride or dicarboxylic acid.

High polar, aprotic solvents such as NMP (N-methyl pyrrolidone), DMF (N,N-dimethylformamide), DMAc (N,N-dimethylacetamide) and DMSO (dimethylsulfoxide) are preferably used as an organic solvent for synthesis of polyamideimide copolymer in the present invention. Aliphatic hydrocarbons such as cyclohexane, pentane and hexane, aromatic hydrocarbons such as benzene, toluene and chlorobenzene, ethers such as THF (tetrahydrofuran), diethylether and ethyleneglycol diethylether, ketones such as acetone, methylethyl ketone and 4-methyl-2-pentanone, and esters such as methyl propionate, ethyl acetate and butyl acetate may be also used as long as reaction substrates and target products are sufficiently soluble in these solvents. These solvents may be used as a mixture.

The amount of these organic solvents to be used is preferably 0.8 to 5 times (by weight) of the polyamideimide resin to be formed. A proportion of less than 0.8 times causes an excessively high concentration of the polymer in the synthesis process, making it difficult to perform stirring and hence synthesis, while a proportion of exceeding 5 times tends to decrease the reaction speed.

The reaction temperature for obtaining the polymer is usually 80 to 210°C, preferably 100 to 190°C, and more preferably 120 to 180°C. While the temperature may be constant from the start to the end of the reaction, the temperature may be low at the initial stage of the reaction with a temperature increase thereafter. A reaction temperature of below 80°C makes the reaction speed low, which causes an excessively long reaction time possibly leading to insufficient molecular weight, while a temperature exceeding 210°C tends to form a gel during the reaction.

The reaction time is usually 1 to 10 hours, preferably 2 to 5 hours, by taking the progress of the polymerization into consideration.

A catalyst may be added in the reaction system, if necessary. Examples of the catalyst available include tertiary alkyl amines such as N,N,N',N'-tetramethyl-1,3-butanediamine, triethylamine and tributylamine; condensed cyclic amines such as 1,4-diazabicyclo[2.2.2]octane and 1,8-diazabicyclo[5.4.0]unde-7-ene; phosphorous compounds such as 1-phenyl-2-phosphorene-1-oxide and 3-methyl-1-phenyl-2-phosphorene-1-oxide; and metals such as alkali metals, alkali earth metals, tin, zinc, titanium and cobalt.

The polyamideimide resin composition of the present invention contains 100 parts by weight of the polyamideimide resin of the present invention, and 10 to 100 parts by weight of an epoxy resin. Solvent resistance, adhesivity and anti-hygroscopic reflowability of the resulting hardened resin composition may be improved by using the epoxy resin. The amount of the epoxy resin to be used is 10 to 100 parts by weight, preferably 20 to 90 parts by weight, and more preferably 30 to 80parts by weight, relative to 100 parts by weight of the polyamideimide resin. The solvent resistance and anti-reflowability of the hardened resin tend to be decreased when the amount of the epoxy resin is less than 10 parts by weight, while storability, heat resistance and adhesivity of the hardened resin tend to decrease when the amount of the epoxy resin exceeds 100 parts by weight.

Examples of the epoxy resin available in the present invention include bisphenol A epoxy resins such as Epicron 840, 840-S, 850, 850-S, 860, 1050, 1055, 3050, 4050, AM-020-P and AM-030-P; bisphenol F epoxy resins such as Epicron 830, 830-S and 835; cresol novolac epoxy resins such as Epicron N-660, N-665, N-673, N-680, N-660-LE and N-665-LE; phenol novolac epoxy resins such as Epicron N-740, N-770, N-775, N-740-80M and N-770-70M; and flexible epoxy resins such as Epicron TSR-960, TSR-601 and 1600-75X (all manufactured by Dainippon Ink and Chemicals, Inc.); and bisphenol A epoxy resins such as Epicoat 825, 827, 828, 828EL, 828XA, 834, 1001, 1002, 1003, 1055, 1004, 1004AF, 1007, 1009 and 1010 manufactured by Japan Epoxy Resins Co.,Ltd. However, the epoxy resin is not restricted thereto. Each of the epoxy resins may be used alone, or as a combination of at least two of them.

A hardening agent may be added to the polyamideimide resin composition of the present invention. Known hardening agents used for epoxy resins may be used, and examples of them include amines, polyamide resins, novolac resins and acid anhydrides.

Examples of the amines include aromatic polyamines such as 4,4'-diaminodiphenyl methane, 4,4'-diaminodiphenyl ether and p-phenylenediamine; aliphatic polyamines such as diethylene triamine, triethylene triamine, metaxylene diamine and bis(4-amino-3-methylcyclohexyl)methane; piperidine, pyrrolidine, imidazole and their derivatives; and secondary and tertiary amines such as triethylamine, N,N,N',N'-tetramethyl hexamethylenediamine, 1,8-diazabicyclo[5.4.0]undecene, 1,4-diazabicyclo[2.2.2]octane and picoline.

Examples of the polyamide resin include reaction products of aliphatic dicarboxylic acids, dimer acids and trimer acids with polyamines.

Examples of the novolac resins include low molecular weight resin compositions obtained by condensation of phenol and formaldehyde, and condensation of a mixture of phenol, cresol and dihydroxybenzene with formaldehyde.

Examples of the acid anhydride include acid anhydride such as phthalic acid anhydride, trimellitic acid anhydride, pyrromellitic acid anhydride, benzophenone tetracarboxylic acid anhydride, methyl tetrahydrophthalic acid anhydride and succinic acid anhydride, and mixtures thereof.

The method for adding the epoxy resin to the polyamideimide resin of the present invention is not particularly restricted. For example, the epoxy resin to be added is previously dissolved in the same solvent as the solvent used for producing the polyamideimide resin, and the solution is added to the polyamideimide resin solution. Alternatively, the epoxy resin may be directly added to the polyamideimide resin.

Organic and inorganic fillers, surfactants such as defoaming agents and leveling agents, coloring agents such as dyes and pigments, heat stabilizers, antiaging agents, fire retardants and slip agents may be added to the polyamideimide resin and polyamideimide resin composition of the present invention for improving workability of coating and film characteristics before and after forming the coating film.

The polyamideimide resin and polyamideimide resin composition of the present invention are favorable to be used as film forming materials used for forming interlayer insulation films, surface protective films, solder resist films and adhesive films in printed circuit boards, and as adhesives for electronic parts.

### EXAMPLES

While the invention is described in detail hereinafter with reference to examples, the invention is by no means restricted to these examples.

### Example 1

Added in a 500 mL separable flask equipped with a stirrer, reflux column and nitrogen inlet tube were 8.88 g (2.5 mmol) of Hycar CTBN 1300 × 8 (made by Ube Industries Ltd.) as an acrylonitrile butadiene copolymer having carboxylic groups at both terminals, 2.10 g (0.5 mmol) of Hycar CTB 2000 × 162 (made by Ube Industries Ltd.) as a butadiene copolymer having carboxylic groups at both terminals, and 66.2 g of N-methyl pyrrolidone (abbreviated as NMP hereinafter), and the mixture was dissolved homogeneously by heating at 60°C. Added therein was 24.46 g (47 mmol) of 2,2-bis[4-(3,4-dicarboxyphenoxy)phenyl]propane dianhydride (abbreviated as BSAA hereinafter) as an aromatic tetracarboxylic acid dianhydride and, after dissolving the compound, 8.71 g (50 mmol) of tolylene diisocyanate (a mixture of 2,4-substituted compound and 2,6-substituted compound, abbreviated as TDI hereinafter) as an aromatic diisocyanate was added. The mixture was heated to 170°C, and then stirred for 2 hours. The reaction was completed by confirming that absorption peaks of the isocyanate at 2270 cm⁻¹ and of acid anhydride at 1854 cm⁻¹ in the IR spectrum had been disappeared. The reaction system was cooled to room temperature in water bath after completing the reaction.

The reaction solution was diluted with NMP, and the polymer solution obtained was poured into methanol with vigorous stirring to allow the resin to precipitate. The precipitated resin was isolated by filtration. The resin obtained was further washed with methanol, and was dried at 60°C for 48 hours using a hot-air circulating drier to obtain 36.6 g (yield 92%) of a resin powder.

The structure of the resin powder obtained was confirmed to be a desired polyamideimide resin from an IR spectrum, which showed peaks around 1778 cm⁻¹ and 1726 cm⁻¹ assigned to the imide group and a peak around 2240 cm⁻¹ assigned to the nitrile group.

The number average molecular weight and molecular weight distribution of the resin obtained were 12000 and 4.2, respectively, as determined by GPC using polyethyleneglycol as a reference material.

### Example 2

A resin powder (40.5g, yield 92%) was obtained in the same manner as that of Example 1, except that 5.33 g (1.5 mmol) of Hycar CTBN 1300 × 8, 10.50 g (2.5 mmol) of Hycar CTB 2000 × 162, 72.71 g of NMP, 23.94 g (46 mmol) of BSAA and 8.71 g (50 mmol) of TDI were used.

The structure of the resin powder obtained was confirmed to be a desired polyamideimide resin from an IR spectrum, which showed peaks around 1780 cm⁻¹ and 1730 cm⁻¹ assigned to the imide group and a peak around 2240 cm⁻¹ assigned to the nitrile group.

The number average molecular weight and molecular weight distribution of the resin obtained were 11000 and 3.5, respectively, as determined by GPC using polyethyleneglycol as a reference material.

### Example 3

A resin powder (43.8g, yield 93%) was obtained in the same manner as that of Example 1, except that 8.88 g (2.5 mmol) of Hycar CTBN 1300 × 8, 10.50 g (2.5 mmol) of Hycar CTB 2000 × 162, 77.26 g of NMP, 23.42 g (45 mmol) of BSAA and 8.71 g (50 mmol) of TDI were used.

The structure of the resin powder obtained was confirmed to be a desired polyamideimide resin from an IR spectrum, which showed peaks around 1780 cm⁻¹ and 1730 cm⁻¹ assigned to the imide group and a peak around 2240 cm⁻¹ assigned to the nitrile group.

The number average molecular weight and molecular weight distribution of the resin obtained were 10000 and 3.5, respectively, as determined by GPC using polyethyleneglycol as a reference material.

### Example 4

A resin powder (45.7g, yield 91%) was obtained in the same manner as that of Example 1, except that 1.78 g (0.5 mmol) of Hycar CTBN 1300 × 8, 21.00 g (5.0 mmol) of Hycar CTB 2000 × 162, 82.0 g of NMP, 23.16 g (44.5 mmol) of BSAA and 8.71 g (50 mmol) of TDI were used.

The structure of the resin powder obtained was confirmed to be a desired polyamideimide resin from an IR spectrum, which showed peaks around 1780 cm⁻¹ and 1730 cm⁻¹ assigned to the imide group and a peak around 2240 cm⁻¹ assigned to the nitrile group.

The number average molecular weight and molecular weight distribution of the resin obtained were 12000 and 4.0, respectively, as determined by GPC using polyethyleneglycol as a reference material.

### Example 5

A resin powder (53.5g, yield 95%) was obtained in the same manner as that of Example 1, except that 8.88 g (2.5 mmol) of Hycar CTBN 1300 × 8, 21.00 g (5.0 mmol) of Hycar CTB 2000 × 162, 91.1 g of NMP, 22.12 g (42.5 mmol) of BSAA and 8.71 g (50 mmol) of TDI were used.

The structure of the resin powder obtained was confirmed to be a desired polyamideimide resin from an IR spectrum, which showed peaks around 1780 cm⁻¹ and 1730 cm⁻¹ assigned to the imide group and a peak around 2240 cm⁻¹ assigned to the nitrile group.

The number average molecular weight and molecular weight distribution of the resin obtained were 13000 and 4.3, respectively, as determined by GPC using polyethyleneglycol as a reference material.

### Example 6

A resin powder (52.7 g, yield 95%) was obtained in the same manner as that of Example 1, except that 13.31 g (3.75 mmol) of Hycar CTBN 1300 × 8, 15.75 g (3.75 mmol) of Hycar CTB 2000 × 162, 89.84 g of NMP, 22.12 g (42.5 mmol) of BSAA and 8.71 g (50 mmol) of TDI were used.

The structure of the resin powder obtained was confirmed to be a desired polyamideimide resin from an IR spectrum, which showed peaks around 1780 cm⁻¹ and 1730 cm⁻¹ assigned to the imide group and a peak around 2240 cm⁻¹ assigned to the nitrile group.

The number average molecular weight and molecular weight distribution of the resin obtained were 12500 and 4.5, respectively, as determined by GPC using polyethyleneglycol as a reference material.

### Example 7

A resin powder (60.7g, yield 95%) was obtained in the same manner as that of Example 1, except that 17.75 g (5.0 mmol) of Hycar CTBN 1300 × 8, 21.00 g (5.0 mmol) of Hycar CTB 2000 × 162, 102.42 g of NMP, 20.82 g (40.0 mmol) of BSAA and 8.71 g (50 mmol) of TDI were used.

The structure of the resin powder obtained was confirmed to be a desired polyamideimide resin from an IR spectrum, which showed peaks around 1780 cm⁻¹ and 1730 cm⁻¹ assigned to the imide group and a peak around 2240 cm⁻¹ assigned to the nitrile group.

The number average molecular weight and molecular weight distribution of the resin obtained were 15000 and 5.0, respectively, as determined by GPC using polyethylene glycol as a reference material.

### Example 8

A resin powder (65.2 g, yield 95%) was obtained in the same manner as that of Example 1, except that 1.78 g (0.5 mmol) of Hycar CTBN 1300 × 8, 42.00 g (10.0 mmol) of Hycar CTB 2000 × 162, 72.70 g of NMP, 20.56 g (39.5 mmol) of BSAA and 8.71 g (50 mmol) of TDI were used.

The structure of the resin powder obtained was confirmed to be a desired polyamideimide resin from an IR spectrum, which showed peaks around 1780 cm⁻¹ and 1730 cm⁻¹ assigned to the imide group and a peak around 2240 cm⁻¹ assigned to the nitrile group.

The number average molecular weight and molecular weight distribution of the resin obtained were 14000 and 4.1, respectively, as determined by GPC using polyethyleneglycol as a reference material.

### Example 9

A resin powder (68.7g, yield 92%) was obtained in the same manner as that of Example 1, except that 8.88 g (2.5 mmol) of Hycar CTBN 1300 × 8, 42.00 g (10.0 mmol) of Hycar CTB 2000 × 162, 118.7 g of NMP, 19.52 g (37.5 mmol) of BSAA and 8.71 g (50 mmol) of TDI were used.

The structure of the resin powder obtained was confirmed to be a desired polyamideimide resin from an IR spectrum, which showed peaks around 1780 cm⁻¹ and 1730 cm⁻¹ assigned to the imide group and a peak around 2240 cm⁻¹ assigned to the nitrile group.

The number average molecular weight and molecular weight distribution of the resin obtained were 17000 and 4.1, respectively, as determined by GPC using polyethyleneglycol as a reference material.

### Comparative Example 1

A resin powder (44.8 g, yield 92%) was obtained in the same manner as that of Example 1, except that Hycar CTBN 1300 × 8 was not used, and 21.00 g (5.0 mmol) of Hycar CTB 2000 × 162, 79.70 g of NMP, 23.42 g (45.0 mmol) of BSAA and 8.71 g (50 mmol) of TDI were used.

The structure of the resin powder obtained was confirmed to be a desired polyamideimide resin from an IR spectrum, which showed peaks around 1780 cm⁻¹ and 1730 cm⁻¹ assigned to the imide group and a peak around 2240 cm⁻¹ assigned to the nitrile group.

The number average molecular weight and molecular weight distribution of the resin obtained were 11000 and 3.5, respectively, as determined by GPC using polyethyleneglycol as a reference material.

### Comparative Example 2

A resin powder (58.5 g, yield 94%) was obtained in the same manner as that of Example 1, except that 26.63 g (7.5 mmol) of Hycar CTBN 1300 × 8, 10.5 g (2.5 mmol) of Hycar CTB 2000 × 162, 72.70 g of NMP, 20.82 g (40.0 mmol) of BSAA and 8.71 g (50 mmol) of TDI were used.

The structure of the resin powder obtained was confirmed to be a desired polyamideimide resin from an IR spectrum, which showed peaks around 1780 cm⁻¹ and 1730 cm⁻¹ assigned to the imide group and a peak around 2240 cm⁻¹ assigned to the nitrile group.

The number average molecular weight and molecular weight distribution of the resin obtained were 12000 and 3.5, respectively, as determined by GPC using polyethyleneglycol as a reference material.

### Comparative example 3

A resin powder (40.5 g, yield 92%) was obtained in the same manner as that of Example 1, except that Hycar CTBN 1300 × 8 was not used, and 35.50 g (10.0 mmol) of Hycar CTB 2000 × 162, 97.5 g of NMP, 23.42 g (45.00 mmol) of BSAA and 8.71 g (50 mmol) of TDI were used.

The structure of the resin powder obtained was confirmed to be a desired polyamideimide resin from an IR spectrum, which showed peaks around 1780 cm⁻¹ and 1730 cm⁻¹ assigned to the imide group and a peak around 2240 cm⁻¹ assigned to the nitrile group.

The number average molecular weight and molecular weight distribution of the resin obtained were 15000 and 4.0, respectively, as determined by GPC using polyethyleneglycol as a reference material.

The components and blending ratios thereof used in Examples 1 to 9 and Comparative Examples 1 to 3 are shown in Table 1.

**TABLE 1**

| | TDI (mmol) | BSAA (mmol) | Acrylonitrile- butadiene copolymer having carboxylic groups at both terminals (mmol) | Butadiene polymer having carboxylic groups at both terminals (mmol) | Number average molecular weight/molecular weight distribution | Polymer Composition | | |
|---|---|---|---|---|---|---|---|---|
| | | | | | | k/(k+m+n) | m/(k+m+n) | n/(k+m+n) |
| Example 1 | 50 | 47 | 2.5 | 0.5 | 12000/4.2 | 0.94 | 0.05 | 0.01 |
| Example 2 | 50 | 46 | 1.5 | 2.5 | 11000/3.5 | 0.92 | 0.03 | 0.05 |
| Example 3 | 50 | 45 | 2.5 | 2.5 | 10000/3.5 | 0.90 | 0.05 | 0.05 |
| Example 4 | 50 | 44.5 | 0.5 | 5.0 | 12000/4.0 | 0.89 | 0.01 | 0.10 |
| Example 5 | 50 | 42.5 | 2.5 | 5.0 | 13000/4.3 | 0.85 | 0.05 | 0.1 |
| Example 6 | 50 | 42.5 | 3.75 | 3.75 | 12500/4.5 | 0.85 | 0.075 | 0.075 |
| Example 7 | 50 | 40.0 | 5.0 | 5.0 | 15000/5.0 | 0.80 | 0.1 | 0.1 |
| Example 8 | 50 | 39.5 | 0.5 | 10.0 | 14000/4.1 | 0.79 | 0.01 | 0.2 |
| Example 9 | 50 | 37.5 | 2.5 | 10.0 | 17000/4.1 | 0.75 | 0.05 | 0.2 |
| Comparative Example 1 | 50 | 45 | . | 5.0 | 11000/3.5 | 0.90 | 0.00 | 0.1 |
| Comparative Example 2 | 50 | 40 | 7.5 | 2.5 | 12000/3.5 | 0.80 | 0.15 | 0.05 |
| Comparative Example 3 | 50 | 40 | 10.0 | - | 15000/4.0 | 0.80 | 0.20 | 0.00 |

### Example 10

Added in 100 parts by weight of a resin fraction in the polyamideimide resin obtained in Example 1 were 60 parts by weight of an epoxy resin (bisphenol A epoxy resin, Epicron 840S, manufactured by Dainippon Ink and Chemicals Inc.), 34 parts by weight of a hardening agent (a phenol resin Tamanol P-180, manufactured by Arakawa Chemical Industries Ltd.) and an amine catalyst (Curesol C11Z, manufactured by Shikoku Chemicals Co.), and a polyamideimide resin composition containing 40% by weight of non-volatile fraction was obtained by diluting the mixture with N,N-dimethylacetamide.

### Example 11

A polyamideimide resin composition containing 40% by weight of non-volatile fraction was obtained in the same manner as that of Example 10, except that the resin obtained in Example 2 was used as the polyamideimide resin.

### Example 12

A polyamideimide resin composition containing 40% by weight of non-volatile fraction was obtained in the same manner as that of Example 10, except that the resin obtained in Example 3 was used as the polyamideimide resin.

### Example 13

A polyamideimide resin composition containing 40% by weight of non-volatile fraction was obtained in the same manner as that of Example 10, except that the resin obtained in Example 4 was used as the polyamideimide resin.

### Example 14

A polyamideimide resin composition containing 40% by weight of non-volatile fraction was obtained in the same manner as that of Example 10, except that the resin obtained in Example 5 was used as the polyamideimide resin.

### Example 15

A polyamideimide resin composition containing 40% by weight of non-volatile fraction was obtained in the same manner as that of Example 10, except that the resin obtained in Example 6 was used as the polyamideimide resin.

### Example 16

A polyamideimide resin composition containing 40% by weight of non-volatile fraction was obtained in the same manner as that of Example 10, except that the resin obtained in Example 7 was used as the polyamideimide resin.

### Example 17

A polyamideimide resin composition containing 40% by weight of non-volatile fraction was obtained in the same manner as that of Example 10, except that the resin obtained in Example 8 was used as the polyamideimide resin.

### Example 18

A polyamideimide resin composition containing 40% by weight of non-volatile fraction was obtained in the same manner as that of Example 10, except that the resin obtained in Example 9 was used as the polyamideimide resin.

### Comparative Example 4

Added in 100 parts by weight of a resin fraction in a resin (type-0, manufactured by Tomoegawa Paper Co.) mainly comprising an aromatic polyamide-acrylonitrile-butadiene copolymer were 60 parts by weight of an epoxy resin (bisphenol A epoxy resin, Epicron 1055, manufactured by Dainippon Ink and Chemicals Inc.), a hardening agent (a phenol resin, Tamanol P-180, manufactured by Arakawa Chemical Industries Co.) and an amine catalyst (Curesol C11Z, manufactured by Shikoku Chemicals Co.), and a polyamideimide resin composition containing 40% by weight of non-volatile fraction was obtained by diluting the mixture with a mixed solvent of methylethyl ketone and N,N-dimethylacetamide.

### Comparative Example 5

A polyamideimide resin composition containing 40% by weight of non-volatile fraction was obtained in the same manner as that of Example 10, except that the resin obtained in Comparative Example 1 was used as the polyamideimide resin.

### Comparative Example 6

A polyamideimide resin composition containing 40% by weight of non-volatile fraction was obtained in the same manner as that of Example 10, except that the resin obtained in Comparative Example 2 was used as the polyamideimide resin.

### Comparative Example 7

A polyamideimide resin composition containing 40% by weight of non-volatile fraction was obtained in the same manner as that of Example 10, except that the resin obtained in Comparative Example 3 was used as the polyamideimide resin.

The resin compositions obtained in Examples 10 to 18 and Comparative Examples 4 to 7 were tested as follows.

### (Preparation of adhesive films)

The polyamideimide resin composition obtained in Example 10 was applied on a polyethylene terephthalate film (with a thickness of 25 µm) one surface of which was treated with silicone, and an adhesive film with a thickness of 25 µm was prepared by drying at 120°C for 10 minutes. Adhesive films were also prepared using the polyamideimide resin compositions obtained in Examples 11 to 18 and Comparative Examples 4 to 7.

### (Measurement of elastic modulus of the adhesive film)

After completely hardening the adhesive film obtained above by heating at 180°C for 90 minutes, the elastic modulus was measured using a dynamic viscoelastometer (trade name DMS 120, manufactured by Seiko Instruments Co.). The heating rate was 10 °C/minute.

### (Measurement of adhesive strength of adhesive film (ICP-TM-650 2.4.9))

The adhesive film obtained above was adhered on a copper side face of a bifacial substrate (polyamide/copper) by pressing, and was hardened by heating at 180°C for 90 minutes. The film obtained was subjected to a 90° peeling test to measure the adhesive strength of the film.

### (Measurement of volume resistivity of adhesive film)

After completely hardening the adhesive film obtained above by heating at 180°C for 90 minutes, a conductive paste was applied on the film as electrodes to measure the volume resistivity of the film.

### (Measurement of hygroscopic coefficient of adhesive film)

After completely hardening the adhesive film obtained above by heating at 180°C for 90 minutes, the film was placed in a constant temperature-constant humidity environment (85% RH) at 85°C for 48 hours, and thereafter the hygroscopic coefficient of the adhesive film was measured by the Karl-Fisher method.

### (High humidity bias test of adhesive film)

Comb-shaped patterns with a line/space widths of 100 µm/100 µm were formed on a polyimide film, and a sample was prepared by adhering the adhesive film on the polyimide film. The insulation resistance of this sample was measured for 1000 hours under a condition of 60°C/95% RH while a direct current voltage of 15V was applied. The sample that maintained an insulation resistance of no less than 5 × 10⁸ Ω for 1000 hours was evaluated as good (O), the sample that showed a decrease of the resistance of below 5 × 10⁸ Ω during the measurement was evaluated as relatively good (Δ), and the sample that showed a resistance of less than 5 × 10⁸ Ω immediately after the start of the measurement was evaluated as poor (×).

### (Hygroscopic reflow test of adhesive film)

A three-layer test substrate was prepared using the adhesive film above. The test substrate was allowed to absorb moisture by standing it under a condition of 30°C/60% RH for 168 hours, and was allowed to pass through a reflow furnace (peak temperature 260°C) three times thereafter. Foaming (swelling) in the substrate, if any, was confirmed by visual test, and the sample showing no foaming was evaluated as good (O) while the foamed sample was evaluated as poor (x).

**TABLE 2**

| | Applicability | Storage Modulus (GPa) | Adhesive Strength (kN/m) | Volume Resistivity (Ω·cm) | Hygroscopicity (%) | High humidity bias test Interline resistance (Ω) | | | Hygroscopic Reflow Test |
|---|---|---|---|---|---|---|---|---|---|
| | | | | | | Initial | After 1000 hours | Evaluation | |
| Example 10 | ○ | 1.5 | 0.9 | 2.0E+15 | 0.75 | 1.0E+13 | 1.3E+09 | ○ | ○ |
| Example 11 | ○ | 1.0 | 0.9 | 3.7E+16 | 0.73 | 1.0E+13 | 1.5E+09 | ○ | ○ |
| Example 12 | ○ | 0.8 | 0.9 | 1.8E+15 | 0.52 | 1.0E+ 13 | 1.0E+09 | ○ | ○ |
| Example 13 | ○ | 0.8 | 0.5 | 4.0E+16 | 0.50 | 1.0E+13 | 3.6E+09 | ○ | ○ |
| Example 14 | ○ | 0.5 | 0.7 | 2.0E+16 | 0.63 | 1.0E+13 | 2.0E+09 | ○ | ○ |
| Example 15 | ○ | 0.5 | 0.9 | 7.5E+14 | 0.55 | 1.0E+13 | 9.7E+08 | Δ(500H) | ○ |
| Example 16 | ○ | 0.4 | 1.0 | 3.6E+13 | 0.57 | 1.0E+ 13 | 8.0E+08 | Δ(300H) | ○ |
| Example 17 | ○ | 0.5 | 0.5 | 5.0E+16 | 0.61 | 1.0E+13 | 2.5E+09 | ○ | ○ |
| Example 18 | ○ | 0.4 | 0.5 | 1.0E+16 | 0.50 | 1.0E+ 13 | 1,0E+09 | ○ | ○ |
| Comparative Example 4 | ○ | 0.4 | 1.2 | 1.0E+14 | 1.20 | 1.0E+ 12 | <1.0E+6 | ×(Initial) | × |
| Comparative **Example 5** | × | 0.5 | 0.5 | 5.0E+16 | 0.58 | 1.OE+13 | 2.0E+09 | ○ | × |
| Comparative Example 6 | ○ | 0.4 | 1.0 | 5.0E+14 | 0.70 | 5.0E+12 | <1.0E+6 | × (Initial) | ○ |
| Comparative Example 7 | ○ | 0.4 | 1.5 | 8.0E+13 | 0.80 | 8.0E+11 | <1.0E+6 | × (Initial) | ○ |

Table 2 shows that the polyamideimide resin compositions in the examples have the same levels of elastic modulus as those of the polyamide resin compositions in Comparative Example 4 and polyamideimide resin compositions in Comparative Examples 5 to 7, and have excellent adhesive strength to the substrate while insulation characteristics thereof are excellent with large volume resistivity. In addition, the polyamideimide resin compositions in the examples has lower hygroscopicity than that of the polyamide resin in the comparative examples while the former is also excellent in high humidity bias characteristics and hygroscopic reflow characteristics.

## Claims

1. A polyamideimide resin comprising a structural unit represented by the following general formula (1) and at least one of the structural unit represented by the following general formula (2) and the structural unit represented by the following general formula (3),
the number k of the structural unit represented by the general formula (1), the number m of the structural unit represented by the general formula (2), and the number n of the structural unit represented by the general formula (3) contained in the polyamide resin satisfying the relation of 0 < m/(k + m + n) ≤ 0.1,
the resin containing a polyamideimide copolymer with a number average molecular weight of 2000 to 50000: 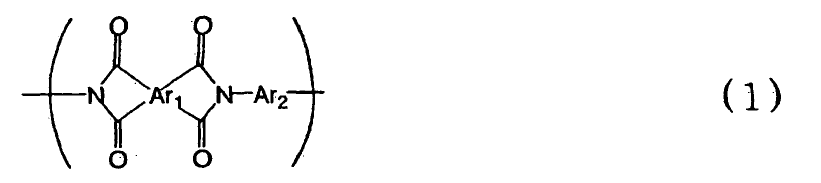 wherein, Ar₁ and Ar₂ each represent an aromatic group that may be substituted, 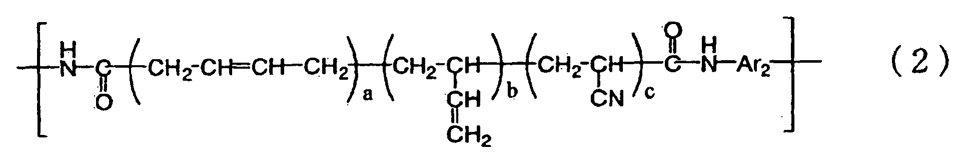 wherein, Ar₂ is defined as described above, and a, b and c each are an integer of 0 to 100 with the relations of the ratio a/b of 0/1 to 1/0, the ratio (a + b)/c of 1/0 to 0/1, and the sum (a + b + c) of 1 to 100, 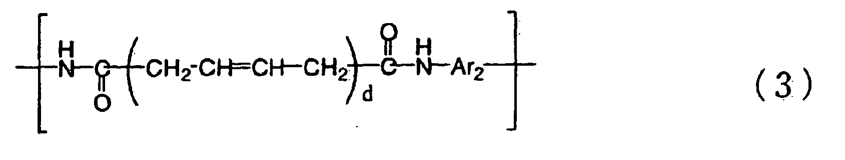 wherein, Ar₂ is defined as described above, and d is an integer of 1 to 100.

2. A method for producing the polyamideimide resin according to claim 1 comprising the steps of:
obtaining the structural unit represented by the general formula (1) by imidation by a decarboxylation reaction between an aromatic diisocyanate represented by the following general formula (4) and an aromatic tetracarboxylic acid dianhydride represented by the following general formula (5);
obtaining the structural unit represented by the general formula (2) by amidation by a decarboxylation reaction between an aromatic diisocyanate represented by the following general formula (4) and a butadiene-containing dicarboxylic acid represented by the following general formula (6); and
obtaining the structural unit represented by the general formula (3) by amidation by a decarboxylation reaction between an aromatic diisocyanate represented by the following general formula (4) and a butadiene-containing dicarboxylic acid represented by the following general formula (7):
OCN-Ar₂-NCO (4)
wherein, Ar₂ is defined as described above, 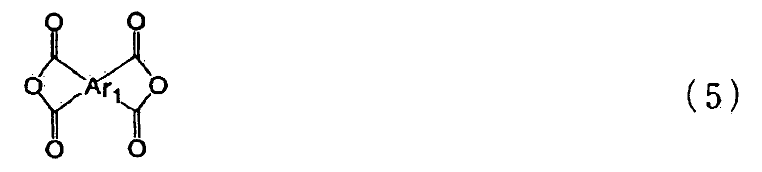 wherein, Ar₁ is defined as described above, 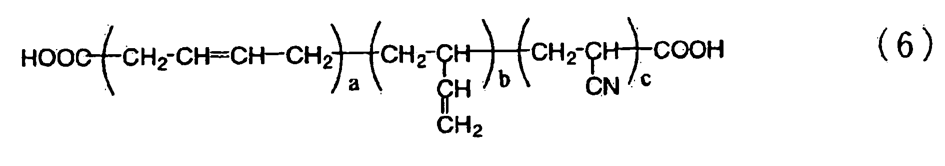 wherein, a, b and c are defined as described above, 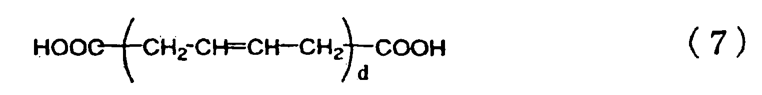 wherein, d is defined as described above.

3. The polyamideimide resin obtainable by the method for producing the polyamideimide resin according to claim 2.

4. The polyamideimide resin according to claim 3, wherein the tetracarboxylic acid dianhydride is 2,2-bis[4-(3,4-dicarboxyphenoxy)phenyl]propane dianhydride represented by the following formula (8):

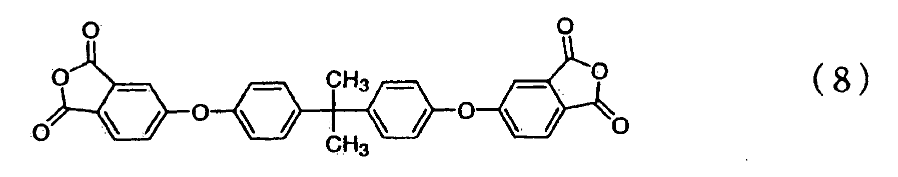

5. A polyamideimide resin composition comprising 10 to 100 parts by weight of an epoxy resin relative to 100 parts by weight of the polyamideimide resin according to any one of claims 1, 3 and 4.

6. A film-forming material comprising the polyamideimide resin according to any one of claims 1, 3 and 4.

7. A film-forming material comprising the polyamideimide resin composition according to claim 5.

8. An adhesive for electronic parts comprising any one of the polyamideimide resin according to any one of claims 1, 3 and 4, and the polyamideimide resin composition according to claim 5.

## Patentansprüche

1. Polyamidimidharz, welches eine durch die nachfolgende allgemeine Formel (1) dargestellte Struktureinheit und mindestens eine von der durch die nachfolgende allgemeine Formel (2) dargestellten Struktureinheit und der durch die nachfolgende allgemeine Formel (3) dargestellten Struktureinheit umfasst,
wobei die Zahl k der Struktureinheit, die durch die allgemeine Formel (1) dargestellt ist, die Zahl m der Struktureinheit, die durch die allgemeine Formel (2) dargestellt ist, und die Zahl n der Struktureinheit, die durch die allgemeine Formel (3) dargestellt ist, welche in dem Polyamidharz enthalten sind, der Beziehung 0<m/(k+m+n)≤0,1 genügen,
das Harz, ein Polyamidimidcopolymer mit einem zahlengemittelten Molekulargewicht von 2000 bis 50.000 enthält: 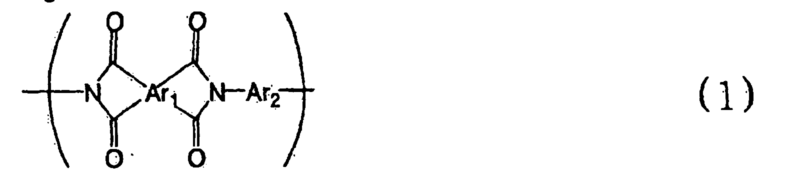 wobei ein jedes Ar₁ und Ar₂ eine aromatische Gruppe darstellt, welche substituiert sein kann, 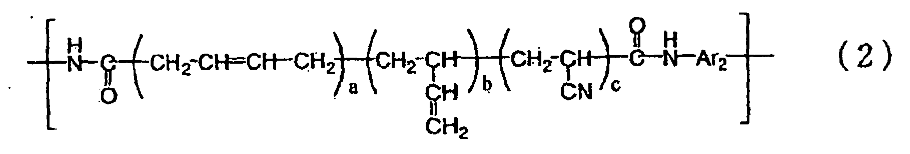 wobei Ar₂ definiert ist wie oben beschrieben wurde und ein jedes a, b und c eine ganze Zahl von 0 bis 100 ist mit den nachfolgenden Relationen ; Verhältnis a/b in dem Bereich von 0/1 bis 1/0, Verhältnis (a+b)/c in dem Bereich von 1/0 bis 0/1, und die Summe (a+b+c) liegt in dem Bereich von 1 bis 100, 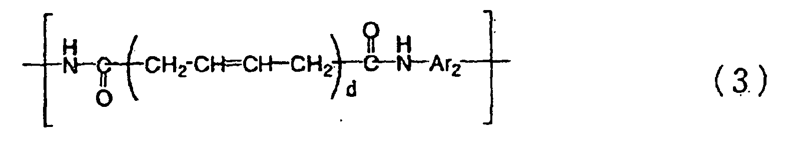 wobei Ar₂ definiert ist wie oben beschrieben wurde und d eine ganze Zahl von 1 bis 100 ist.

2. Verfahren zum Herstellen des Polyamidimidharzes gemäß Anspruch 1, welches die folgenden Schritte umfasst:
das Erzielen der durch die allgemeine Formel (1) dargestellten Struktureinheit durch ein Imidieren mit Hilfe einer Decarboxylierungsreaktion zwischen einem aromatischen Diisocyanat, das durch die nachfolgende allgemeine Formel (4) dargestellt ist, und einem aromatischen Tetracarboxylsäuredianhydrid, das durch die nachfolgende allgemeine Formel (5) dargestellt ist;
das Erzielen der durch die allgemeine Formel (2) dargestellten Struktureinheit durch ein Amidieren mit Hilfe einer Decarboxylierungsreaktion zwischen einem aromatischen Diisocyanat, das durch die nachfolgende allgemeine Formel (4) dargestellt ist, und einer Butadien enthaltenden Dicarboxylsäure, die durch die nachfolgende allgemeine Formel (6) dargestellt ist; und
das Erzielen der durch die allgemeine Formel (3) dargestellten Struktureinheit durch ein Amidieren mit Hilfe einer Decarboxylierungsreaktion zwischen einem aromatischen Diisocyanat, das durch die nachfolgende allgemeine Formel (4) dargestellt ist, und einer Butadien enthaltenden Dicarboxylsäure, die durch die nachfolgende allgemeine Formel (7) dargestellt ist:
OCN-Ar₂-NCO (4)
wobei Ar₂ definiert ist wie oben beschrieben wurde, 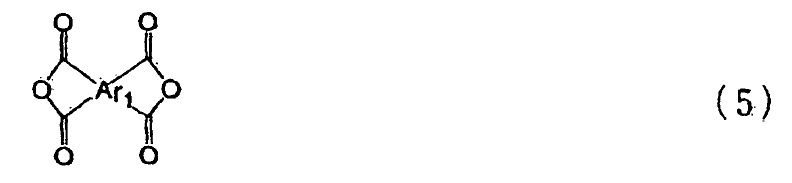 wobei Ar₁ definiert ist wie oben beschrieben wurde, 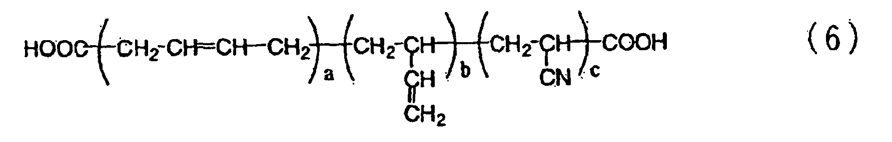 wobei a, b und c definiert sind wie oben beschrieben wurde, 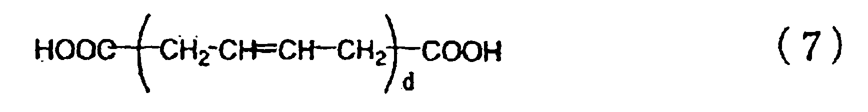 wobei d definiert ist wie oben beschrieben wurde.

3. Polyamidimidharz, das mit Hilfe des Verfahrens zur Herstellung des Polyamidimidharzes gemäß Anspruch 2 erzielt werden kann.

4. Polyamidimidharz gemäß Anspruch 3, bei welchem das Tetracarboxylsäuredianhydrid 2,2-bis[4-(3,4-Dicarboxyphenoxy)phenyl]propan-dianhydrid ist, das durch die nachfolgende Formel (8) dargestellt ist:

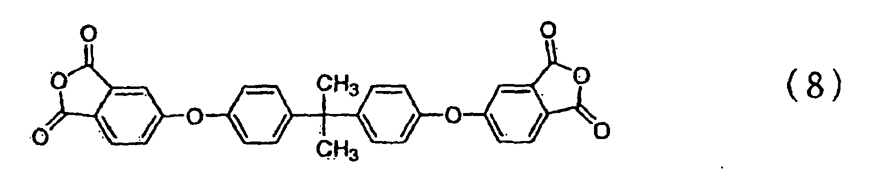

5. Polyamidimidharzzusammensetzung, welche 10 bis 100 Gewichtsteile eines Epoxidharzes gegenüber von 100 Gewichtsteilen des Polyamidimidharzes gemäß irgendeinem der Ansprüche 1, 3 und 4 umfasst.

6. Filmbildendes Material, welches das Polyamidimidharz gemäß irgendeinem der Ansprüche 1, 3 und 4 aufweist.

7. Filmbildendes Material, welches die Polyamidimidharzzusammensetzung gemäß Anspruch 5 aufweist

8. Klebstoff für elektronische Teile, welcher irgendeines der Polyamidimidharze gemäß irgendeinem der Ansprüche 1, 3 und 4 und die Polyamidimidharzzusammensetzung gemäß Anspruch 5 umfasst.

## Revendications

1. Résine de polyamideimide comprenant une unité structurale représentée par la formule générale (1) suivante et au moins l'une de l'unité structurale représentée par la formule générale (2) suivante et de l'unité structurale représentée par la formule générale (3) suivante,
le nombre k de l'unité structurale représentée par la formule générale (1), le nombre m de l'unité structurale représentée par la formule générale (2) et le nombre n de l'unité structurale représentée par la formule générale (3) contenues dans la résine polyamide satisfaisant la relation de 0 < m/(k + m + n) ≤ 0,1,
la résine contenant un copolymère de polyamideimide ayant un poids moléculaire moyen en nombre de 2 000 à 50 000: 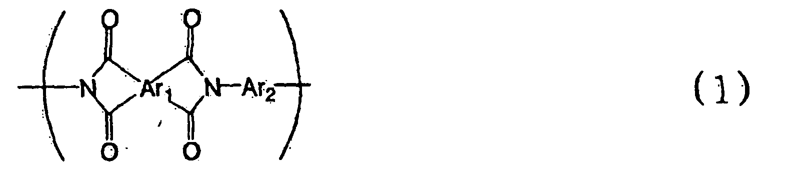 où Ar₁ et Ar₂ représentent chacun un groupe aromatique qui peut être substitué, 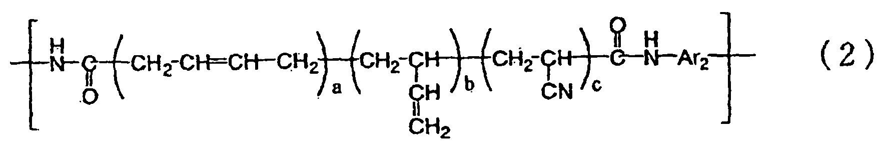 où Ar₂ est défini comme décrit ci-dessus et a, b et c sont chacun un nombre entier de 0 à 100 avec les relations du rapport a/b de 0/1 à 1/0, le rapport (a + b)/c de 1/0 à 0/1, et la somme (a + b + c) de 1 à 100, 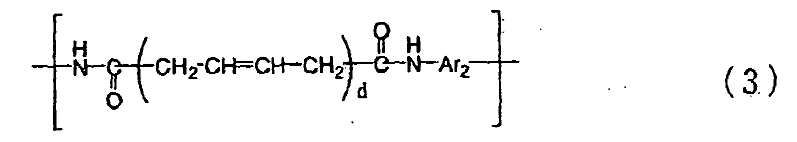 où Ar₂ est défini comme décrit ci-dessus et d est un nombre entier de 1 à 100.

2. Procédé de production de la résine de polyamideimide selon la revendication 1, comprenant les étapes consistant à:
obtenir l'unité structurale représentée par la formule générale (1) par imidation par une réaction de décarboxylation entre un diisocyanate aromatique représenté par la formule générale (4) suivante et un dianhydride de l'acide tétracarboxylique aromatique représenté par la formule générale (5) suivante;
obtenir l'unité structurale représentée par la formule générale (2) par amidation par une réaction de décarboxylation entre un diisocyanate aromatique représenté par la formule générale (4) suivante et un acide dicarboxylique contenant un butadiène représenté par la formule générale (6) suivante; et
obtenir l'unité structurale représentée par la formule générale (3) par amidation par une réaction de décarboxylation entre un diisocyanate aromatique représenté par la formule générale (4) suivante et un acide dicarboxylique contenant un butadiène représenté par la formule générale (7) suivante:
OCN-Ar₂-NCO (4)
où Ar₂ est défini comme décrit ci-dessus, 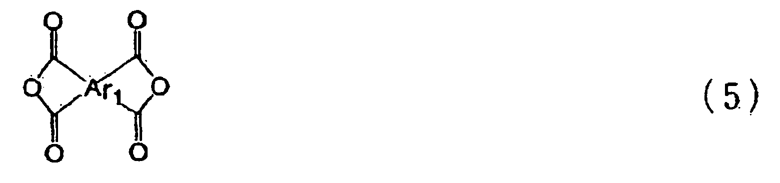 où Ar₁ est défini comme décrit ci-dessus, 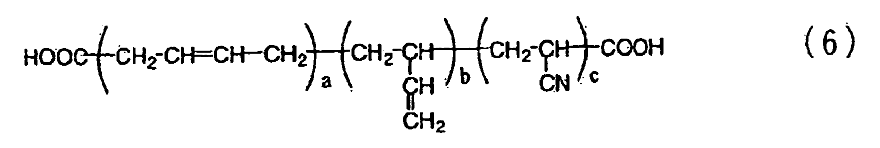 où a, b et c sont définis comme décrit ci-dessus, 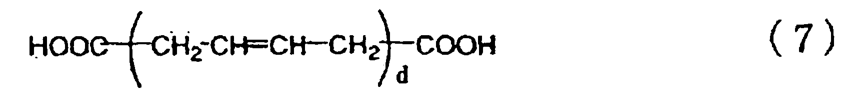 où d est défini comme décrit ci-dessus.

3. Résine de polyamideimide pouvant être obtenue par le procédé de production de la résine de polyamideimide selon la revendication 2.

4. Résine de polyamideimide selon la revendication 3, dans laquelle le dianhydride d'acide tétracarboxylique est le dianhydride de 2,2-bis[4-(3,4-dicarboxyphénoxy)phényl]propane représenté par la formule (8) suivante:

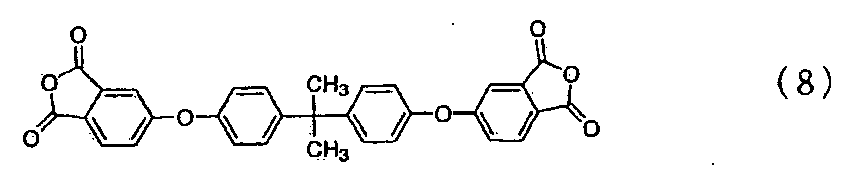

5. Composition de résine de polyamideimide comprenant 10 à 100 parties en poids d'une résine époxy par rapport à 100 parties en poids de la résine de polyamideimide selon l'une quelconque des revendications 1, 3 et 4.

6. Matériau filmogène comprenant la résine de polyamideimide selon l'une quelconque des revendications 1, 3 et 4.

7. Matériau filmogène comprenant la composition de résine de polyamideimide selon la revendication 5.

8. Colle pour composants électroniques comprenant l'une quelconque des résines de polyamideimide selon l'une quelconque des revendications 1, 3 et 4 et la composition de résine de polyamideimide selon la revendication 5.
